Europäisches Patentamt

(19) European Patent Office

Office européen des brevets

(11) Numéro de publication: **0 181 812**
A1

# (12) DEMANDE DE BREVET EUROPEEN

(21) Numéro de dépôt: 85402109.4

(22) Date de dépôt: 04.11.85

(51) Int. Cl.4: **H 01 L 21/28**
**H 01 L 21/00**

(30) Priorité: 06.11.84 FR 8416871

(43) Date de publication de la demande:
21.05.86 Bulletin 86/21

(84) Etats contractants désignés:
DE GB NL

(71) Demandeur: THOMSON-CSF
173, Boulevard Haussmann
F-75379 Paris Cedex 08(FR)

(72) Inventeur: Blanchard, Pierre
THOMSON-CSF SCPI 173, bld Haussmann
F-75379 Paris Cedex 08(FR)

(72) Inventeur: Cortot, Jean-Paul
THOMSON-CSF SCPI 173, bld Haussmann
F-75379 Paris Cedex 08(FR)

(74) Mandataire: Mayeux, Michèle et al,
THOMSON-CSF SCPI 19, avenue de Messine
F-75008 Paris(FR)

(54) Procédé de fabrication de grilles pour circuit intégré.

(57) La présente invention concerne un procédé de fabrication de grilles pour circuit intégré réalisé sur un substrat semi-conducteur (1) en silicium, recouvert d'au moins une couche d'oxyde (2), d'une couche de silicium polycristallin (3), et éventuellement d'une couche de siliciure.

Ce procédé comporte les étapes suivantes:

1°) on dépose successivement une couche de nitrure de silicium (4) et une couche d'oxyde de silicium (5);

2°) on réalise des ouvertures (7) dans ces deux couches par photo-lithogravure;

3°) on élimine partiellement par désoxydation la couche d'oxyde de silicium (5) de façon à mettre à nu la couche de nitrure (4) sur une certaine distance (1) qui détermine l'écartement entre deux grilles consécutives;

4°) on fait croître de l'oxyde (8) dans les ouvertures (7) réalisées au cours de la deuxième étape;

5°) on élimine les zones de nitrure (4) découvertes au cours de la troisième étape, ainsi que l'éventuelle couche de siliciure et la couche de silicium (3) polycristallin sous-jacentes.

Application à la fabrication de grilles faiblement espacées, utilisées par exemple dans les dispositifs à transfert de charge.

FIG_4

# PROCEDE DE FABRICATION DE GRILLES
## POUR CIRCUIT INTEGRE

La présente invention concerne un procédé de fabrication de grilles pour circuit intégré.

Le procédé selon l'invention est utilisé dans le cas de circuits intégrés possédant un réseau de grilles faiblement espacées, tels que par exemple les dispositifs à transfert de charge.

On sait réaliser des grilles faiblement espacées en utilisant des machines de photo-lithographie très performantes. On peut ainsi obtenir un espacement entre grilles de l'ordre de 2 um.

Le problème qui se pose est celui de la réalisation, avec des moyens classiques, de grilles dont l'espacement est inférieur à 2 um.

La présente invention permet de résoudre ce problème et permet d'obtenir des espacements entre grilles pouvant descendre jusqu'à 0,2 um.

Un procédé de fabrication de grilles pour circuit intégré réalisé sur un substrat semi-conducteur en silicium, recouvert d'au moins une couche d'oxyde, d'une couche de silicium polycristallin et éventuellement d'une couche de siliciure, est caractérisé en ce qu'il comporte les étapes suivantes :

1°) on dépose successivement une couche de nitrure de silicium et une couche d'oxyde de silicium ;

2°) on réalise des ouvertures dans ces deux couches par photo-lithogravure ;

3°) on élimine partiellement par désoxydation la couche d'oxyde de silicium de façon à mettre à nu la couche de nitrure sur une certaine distance (l) qui détermine l'écartement entre deux grilles consécutives ;

4°) on fait croître de l'oxyde dans les ouvertures réalisées sur cours de la deuxième étape ;

5°) on élimine les zones de nitrure découvertes au cours de la troisième étape, ainsi que l'éventuelle couche de siliciure et la couche de silicium polycristallin sous-jacentes.

Parmi les avantages du procédé selon l'invention, on peut citer :

- sa simplicité, car il ne nécessite que deux couches supplémentaires, l'une de nitrure et l'autre d'oxyde, pour graver les grilles ;

- le fait que l'écartement entre grilles soit déterminé avec précision, notamment parce qu'il ne dépend pas des fluctuations de l'épaisseur de la couche d'oxyde qui recouvre la couche de nitrure, comme cela sera expliqué dans la suite de la description ;

- le fait qu'il permette d'obtenir aussi bien des grilles en silicium polycristallin que des grilles en silicium polycristallin recouvert de siliciure.

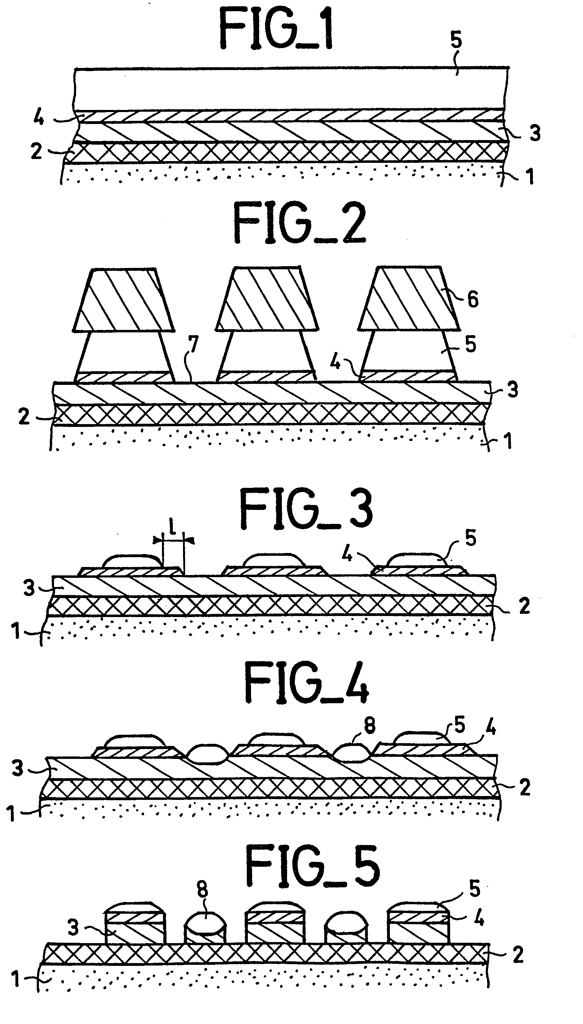

D'autres objets, caractéristiques et résultats de l'invention ressortiront de la description, donnée à titres d'exemple non limitatif et illustrée par les figures 1 à 5 annexées qui représentent diverses étapes d'un mode de réalisation du procédé selon l'invention.

Sur les différentes figures, les mêmes repères désignent les mêmes éléments, mais, pour des raisons de clarté, les cotes et proportions des divers éléments ne sont pas respectées.

Sur la figure 1, on a représenté de façon schématique le substrat semi-conducteur 1 en silicium, qui est recouvert d'au moins une couche d'oxyde 2 et d'une couche de silicium polycristallin 3.

Le procédé selon l'invention s'applique aussi bien pour réaliser des grilles en silicium polycristallin fortement dopé que pour réaliser des grilles formées d'une double couche de silicium polycristallin fortement dopé recouvert d'un siliciure. Dans ce cas, on dépose sur la couche d'oxyde 2 une couche de silicium polycristallin 3 que l'on recouvre d'une couche d'un métal donnant un siliciure, après recuit dans une atmosphère neutre. Le métal utilisé peut être par exemple du tantale.

La première étape du procédé selon l'invention qui est illustrée par la figure 1 consiste à déposer sur la couche 3 une couche 4 de nitrure de silicium $Si_3 N_4$, puis une couche 5 d'oxyde de silicium $Si O_2$.

Le dépôt d'oxyde peut se faire, par exemple, en phase vapeur soit à la pression atmosphérique, soit à basse pression.

A titre d'exemple, on peut utiliser une couche 3 de silicium polycristallin de 5000 A d'épaisseur, une couche 4 de nitrure de silicium de 500 A et une couche 5 d'oxyde de silicium d'1 um d'épaisseur.

Il faut remarquer qu'il n'est pratiquement pas possible de faire croître de l'oxyde sur la couche de nitrure, ce qui impose de déposer l'oxyde sur le nitrure.

On réalise ensuite des ouvertures 7 dans les deux couches 4 et 5, par photo-lithogravure, comme cela est représenté sur la figure 2.

Cette opération définit la largeur d'une grille sur deux.

Pour cela, de manière connue, on dépose sur la couche d'oxyde 5 une résine 6 photosensible de type positif par exemple. On cuit la résine pour la durcir. Ensuite, on applique sur la résine un masque, chrome sur verre par exemple, ayant pour objet de délimiter les fenêtres à ouvrir. On insole la résine aux rayons ultra-violets à travers le masque. On utilise ensuite un produit approprié qui dissout la résine insolée mais laisse subsister la résine non insolée. On grave ensuite l'oxyde et le nitrure pour obtenir les ouvertures 7.

On peut réaliser une gravure chimique ou une gravure sèche par plasma.

Pour que la gravure se limite au nitrure et à l'oxyde et n'attaque pas le silicium polycristallin ou le siliciure, il faut régler le temps d'action du produit utilisé dans le cas d'une gravure chimique et il faut choisir un gaz sélectif approprié s'il s'agit d'une gravure par plasma.

L'étape suivante consiste, après décapage de la résine utilisée précédemment, à éliminer partiellement par désoxydation la couche d'oxyde. L'élimination latérale de cette couche d'oxyde met à nu la couche de nitrure sur une certaine distance. Cette étape est représentée sur la figure 3. On désigne par l la longueur de la couche de nitrure ainsi découverte. Cette étape est très importante car c'est cette longueur l qui va déterminer l'écartement entre deux grilles consécutives.

Il est possible de réaliser cette désoxydation partielle de façon à obtenir avec précision l'écartement entre grille recherché. On calcule le temps pendant lequel il faut laisser agir le produit réalisant la désoxydation en fonction de l'écartement recherché.

Dans des conditions bien définies, on enlève 1000 A d'oxyde par minute. On peut ralentir la désoxydation pour obtenir plus de précision en diluant avec de l'eau le produit utilisé.

Il est très important de noter que la précision obtenue sur la cote l qui est la longueur de la couche de nitrure découverte ne dépend pas de l'épaisseur de la couche d'oxyde 5, mais uniquement de la durée de la désoxydation.

Ainsi même si la couche d'oxyde 5 a une épaisseur variant de 0,8 à 1 um, la longueur de la couche 4 de nitrure découverte reste la même car c'est la désoxydation réalisée latéralement qui détermine la longueur l sans qu'intervienne l'épaisseur de la couche d'oxyde.

Dans l'étape suivante représentée sur la figure 4, on fait croître de l'oxyde dans les ouvertures 7 réalisées au cours de la deuxième étape.

On obtient ainsi des couches d'oxyde 8 localisées aux ouvertures 7 car le nitrure ne s'oxyde pas facilement.

La structure obtenue comporte successivement du nitrure 4, la superposition de nitrure 4 et d'oxyde 5, du nitrure 4, de l'oxyde 8 et ainsi de suite.

Au cours de l'étape suivante illustrée par la figure 5, on élimine les zones où le nitrure 4 est découvert, ainsi que la couche 3 sous-jacente en silicium polycristallin ou en silicium polycristallin recouvert de siliciure.

Cette élimination peut se faire par attaque chimique ou par attaque plasma.

On obtient ainsi comme on peut le voir sur la figure 5 des grilles séparées par la distance l.

Il est possible d'éliminer les couches de nitrure 4 et d'oxyde 5, et d'oxyde 8 qui recouvrent les grilles ainsi obtenues.

On peut après l'étape représentée sur la figure 5 fixer par une photo-lithogravure de la couche d'oxyde 5 les limites du circuit intégré portant des grilles rapprochées. Il est possible aussi de fixer les limites du circuit intégré par exemple après l'étape représentée sur la figure 2.

Avec le procédé selon l'invention, il est possible de réaliser des grilles présentant entre elles un espacement bien défini que l'on peut ·réduire jusqu'à 0,2 um environ. Cet espacement ne dépend pas des techniques de masquage utilisées ni de l'épaisseur de la couche d'oxyde utilisée mais seulement de la précision de la durée de désoxydation.

Ce procédé est particulièrement intéréssant pour la réalisation de dispositifs à transfert de charge du type CCD (pour Charge Couple Device en anglais), qu'ils comportent un seul ou plusieurs niveaux de grilles.

# REVENDICATIONS

1. Procédé de fabrication de grilles pour circuit intégré réalisé sur un substrat semi-conducteur (1) en silicium, recouvert d'au moins une couche d'oxyde (2), d'une couche de silicium polycristallin (3) et éventuellement d'une couche de siliciure, caractérisé en ce qu'il comporte les étapes suivantes :

1°) on dépose successivement une couche de nitrure de silicium (4) et une couche d'oxyde de silicium (5) ;

2°) on réalise des ouvertures (7) dans ces deux couches par photo-lithogravure ;

3°) on élimine partiellement par désoxydation la couche d'oxyde de silicium (5) de façon à mettre à nu la couche de nitrure (4) sur une certaine distance (l) qui détermine l'écartement entre deux grilles consécutives ;

4°) on fait croître de l'oxyde (8) dans les ouvertures (7) réalisées sur cours de la deuxième étape ;

5°) on élimine les zones de nitrure (4) découvertes au cours de la troisième étape, ainsi que l'éventuelle couche de siliciure et la couche de silicium (3) polycristallin sous-jacentes.

2. Procédé selon la revendication 1, caractérisé en ce que la couche d'oxyde de silicium (5) est déposée en phase vapeur, à la pression atmosphérique ou à basse pression.

3. Procédé selon l'une des revendications 1 ou 2, caractérisé en ce que les ouvertures (7) sont réalisées par gravure chimique ou par gravure sèche par plasma.

4. Procédé selon l'une des revendications 1 à 3, caractérisé en ce que l'élimination des zones de nitrure (4) découvertes se fait par gravure chimique ou par gravure sèche par plasma.

# FIG_1

# FIG_2

# FIG_3

# FIG_4

# FIG_5

Office européen
des brevets

**RAPPORT DE RECHERCHE EUROPEENNE**

**0181812**
Numéro de la demande

EP 85 40 2109

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | IEEE ELECTRON DEVICE LETTERS, vol. EDL-2, no. 4, avril 1981, pages 92-94, IEEE, New York, US; V.J. KAPOOR: "Charge-coupled devices with submicron gaps" * En entier * | 1-4 | H 01 L 21/28 H 01 L 21/00 |
| X | GB-A-2 111 304 (PHILIPS) * Figures 46-51 * | 1-4 | |
| A | EP-A-0 098 652 (PHILIPS) * Figures 23-27; page 10, lignes 11-19 * | 1-4 | |
| A | IBM JOURNAL OF RESEARCH & DEVELOPMENT, vol. 24, no. 3, mai 1980, pages 339-347, New York, US; V.L. RIDEOUT et al.: "A one-device memory cell using a single layer of polysilicon and a self-registering metal-to-polysilicon contact" * Page 341, paragraphe 5 - page 342, colonne 2, paragraphe 4; figure 4 * | 1-4 | DOMAINES TECHNIQUES RECHERCHES (Int. Cl.4) H 01 L |
| E | EP-A-0 132 009 (PHILIPS) * Revendications 1-3,8; figures 10-16 * | 1-4 | |

Le présent rapport de recherche a été établi pour toutes les revendications

| Lieu de la recherche | Date d'achèvement de la recherche | Examinateur |
|---|---|---|
| LA HAYE | 17-02-1986 | VANCRAEYNEST F.H. |